# EUROPÄISCHE PATENTSCHRIFT

(11) **EP 1 769 544 B1**
(45) Veröffentlichungstag und Bekanntmachung des Hinweises auf die Patenterteilung: **19.08.2009**
(21) Anmeldenummer: 05770784.6
(22) Anmeldetag: 18.07.2005
(51) Int. Cl.: H01L 41/22, H01L 37/02

(54) **HERSTELLUNG EINER PIEZO- UND PYROELEKTRISCHEN DÜNNSCHICHT AUF EINEM SUBSTRAT**
PRODUCTION OF A PIEZOELECTRIC AND PYROELECTRIC THIN FILM ON A SUBSTRATE
PRODUCTION D'UNE COUCHE MINCE PIEZOELECTRIQUE ET PYROELECTRIQUE SUR UN SUBSTRAT

(30) Priorität: 21.07.2004 DE 102004035386
(43) Veröffentlichungstag der Anmeldung: 04.04.2007
(73) Patentinhaber: ZYRUS Beteiligungsgesellschaft mbH & Co. Patente I KG, 12529 Schönefeld / OT Waltersdorf (DE)
(72) Erfinder: ES-SOUNI, Mohammed, 24247 Mielkendorf (DE)
(74) Vertreter: Rohnke, Christian
(86) Internationale Anmeldenummer: PCT/DE2005/001271
(87) Internationale Veröffentlichungsnummer: WO 2006/007830

(56) Entgegenhaltungen:
- US-B1- 6 327 760
- LI J ET AL: "Preparation of PCLT/P(VDF-TrFE) pyroelectric sensor based on plastic film substrate" SENSORS AND ACTUATORS A, Bd. 100, Nr. 2-3, 1. September 2002 (2002-09-01), Seiten 231-235, XP004374978 ISSN: 0924-4247
- ZHANG Q Q ET AL: "Dielectric and pyroelectric properties of PCaT/P(VDF-TrFE) 0-3 composite thin films" JOURNAL OF NON-CRYSTALLINE SOLIDS, Bd. 254, September 1999 (1999-09), Seiten 118-122, XP004183403 ISSN: 0022-3093

## Beschreibung

Die Erfindung betrifft ein Verfahren zur Herstellung einer piezo- und pyroelecktrischen Dünnschicht auf einem Substrat, insbesondere auf Mikro-Elektromechanischen Systemen (MEMS).

Die Erzeugung piezo- und/oder pyroelektrischer Dünnfilme auf Silizium-basierten MEMS ist für eine Reihe von Anwendungen interessant, z.B. für Ultraschall-Transducer, Drucksensoren, Durchflussmesser, Beschleunigungssensoren, Mikromotoren, Mikropumpen und chemische Sensoren.

Die Beschichtung von Silizium-Chips mit dem konventionellen Sol-Gel-Verfahren führt wegen der hohen Prozesstemperatur von typisch mehr als 500 °C bei der Pyrolyse zu Problemen, insbesondere zur Beschädigung der Siliziumstrukturen.

Die US 6 349 455 B1 lehrt daher, ein möglichst feinkörniges Piezokeramik-Pulver (Korngrößen unter 1 µm) zunächst herzustellen und dann mit einem insbesondere organischen Lösungsmittel zu vermengen, um das Gemisch in einem Tauchprozess auf ein Substrat zu bringen. Durch Anlegen eines elektrischen Feldes werden die Keramikpartikel elektrophoretisch auf dem Substrat deponiert, und der verbliebene Porenraum wird ggf. durch Beimengung eines Sols geeigneter Zusammensetzung zu dem erstgenannten Gemisch ebenfalls infiltriert. Eine anschließende Wärmebehandlung bei Temperaturen zwischen 100°C und 600°C (bevorzugt 150-300°C) entfernt die oder das Lösungsmittel vollständig, so dass eine kompakte keramische Schicht zurückbleibt.

Wünschenswert für die Integration von Funktionsschichten in MEMS sind jedoch Prozesstemperaturen deutlich unter 200°C bei gleichzeitig vereinfachter Bearbeitung.

Eine Möglichkeit, piezoelektrische Werkstoffe unter 200°C herzustellen, besteht darin, Piezokeramikpartikel mit einem Matrixpolymer zu vermengen, das bei entsprechend niedriger Temperatur aushärtet.

Die Herstellung von massiven Bauelementen aus Polymer-Piezokeramik-Kompositen für Anwendungen vor allem in der Ultraschalltechnik ist bekannt. Die Vorteile solche Verbundwerkstoffe sind in der einschlägigen Fachliteratur gut beschrieben (s. z.B. A.J. Moulsen, J.M. Herbert, Electroceramics, Wiley VCH 2003, s. 3 73*).* Für die Herstellung der Komposite können je nach gewünschter Konnektivität verschiedene Verfahren eingesetzt werden. Zur Herstellung der Keramikstruktur eignet sich das Spritzgießen am besten augrund seiner Wirtschaftlichkeit. Nach dem Sintern wird die Piezokeramik gepolt und anschließend mit dem flüssigen Polymer befüllt. Zhang et al. (J. Am. Ceram. Soc. 83(2000), 2227-2230*)* stellen ein Verfahren vor, in dem Nanoteilchen aus mit Lanthan und Kalzium dotiertem Bleititanat in einer Polymerlösung aus Polyvinyldifluorid-Trifluorethylen (PVDF-TrFE) dispergiert und nach Trocknung zu kleinen Scheiben gepresst werden. Zeng et al (J. Appl. Pys. 9(2002)2674-2679*)* berichten über ein ähnliches Verfahren unter Verwendung von Bleizirkonattitanat (PZT) als Piezokeramik.

Die DE 100 17 492 A1 schlägt ein Polymer-Piezokeramik-Komposit zur Beschichtung schwingender Oberflächen vor, um eine passive Schwingungsdämpfung zu erreichen. Die Druckschrift empfiehlt das Heißpressen eines Gemisches aus Polymerpartikeln und Keramikpulver zu einem Film. Ferner wird das Aufspritzen eines Lakkes vorgeschlagen, dem das Keramikpulver beigemengt ist. Typische Filmdicken, die mit diesem Verfahren erzeugt werden, liegen bei 500 Mikrometer.

Die Verwendung piezoelektrischer Polymere und Kopolymere eignet sich besonders zur Herstellung freistehender Filme. Besonders PVDF wird wegen seiner hohen pyro- und piezoelektrischen Koeffizienten geschätzt, wobei sich diese Koeffizienten durch Streckung und Polung des Polymerfilms noch erheblich steigern lassen, siehe z.B. die US 5,254,296. Eine Streckung kommt allerdings nicht für eine direkt auf das Substrat aufgebrachte Dünnschicht in Frage.

Piezo- oder pyroelektrische Dünnschichten (mit Dicken von wenigen Mikrometern oder darunter) auf Substraten werden bislang - mit den herkömmlichen Sol-Gel-Verfahren - vor allem als keramische Schichten realisiert. Die hohen Sintertemperaturen verbieten dabei die Anwendung auf mit empfindlichen Mikrostrukturen versehenen Substraten, z.B. MEMS. Für piezoelektrische Polymerdünnschichten bestehen praktisch keine Erfahrungen.

Die Alternativen, etwa das Aufsprühen dickerer Lacke oder das Aufkleben von Polymerfilmen, sind vom Standpunkt der Mikrotechnik aus ungünstig, schon weil sie nicht mit den üblichen Verfahren der Chipfertigung kompatibel sind.

Zur Herstellung eines pyroelektrischen Sensors ist aus J Li et al (Sensors and Actuators A 100 (2002), 231-235) bekannt, eine Polymerlösung aus VDF/TrFE in MEK herzustellen, darin PCLT Keramikpulver zu dispergieren, einen Kompositfilm auf einem Substrat aufzubringen und diesen bei 100°C zu trocknen.

Es ist die Aufgabe der Erfindung, ein einfaches Verfahren zur Erzeugung von piezo- und/oder pyroelektrischen Dünnschichten auf beliebigen Substraten, insbesondere Si-MEMS, anzugeben, das sich einfach in den Fertigungsprozess integrieren lässt und bei dem die Schichten weit unterhalb 200°C ausgehärtet werden, wobei sie zugleich die elektrischen Eigenschaften von PVDF-Filmen erreichen oder sogar übertreffen.

Die Aufgabe wird gelöst mit einem Verfahren mit den Merkmalen des Hauptanspruchs. Die Unteransprüche geben vorteilhafte Ausgestaltungen an.

Erfindungsgemäß wird eine Polymer-Piezokeramik-Komposit-Schicht auf das Substrat gebracht, indem zunächst eine Keramikpulver-Dispersion mit einer Polymerlösung zu einem Kompositschlicker vermengt und nach Art eines Sol-Gel-Verfahrens auf das Substrat aufgeschleudert wird. Eine abschließende Wärmebehandlung der Schicht bei Temperaturen um etwa 100°C liefert einen haltbaren Film mit ausgezeichneten pyro- und piezoelektrischen Eigenschaften. Das erfindungsgemäße Verfahren ist für weitgehend beliebige Keramikpulver und Matrixpolymere anwendbar und wird konkret für einen PZT-PMMA-Kompositfilm beschrieben (PMMA = Polymethylmethacrylat).

Zur näheren Erläuterung der Erfindung dient die Zeichnung Dabei zeigt:
- Fig. 1: ein Schema zur Herstellung einer PMMA-Lösung,
- Fig. 2: ein Schema zur Herstellung einer PZT-Pulver-Suspension, und
- Fig. 3: piezoelektrische Messungen für Kompositfilme mit unterschiedlichem PZT-Feststoffgehalt.

Das erfindungsgemäße Verfahren umfasst die folgenden Arbeitsschritte:
- Hydrophobieren und Mahlen eines kommerziell erhältlichen Keramikpulvers
- Herstellen einer Keramikpulver-Suspension
- Herstellen einer Polymerlösung
- Vermengen von Keramikpulver-Suspension und Polymerlösung zu einem Kompositschlicker, vorzugsweise im Mischungsverhältnis zwischen 1:1 1 und 3:2
- Aufbringen des Kompositschlickers auf ein Substrat, vorzugsweise durch Aufschleudern, zur Erzeugung einer Kompositschicht, und
- Trocknen der aufgebrachten Schicht bei Temperaturen um 100°C.

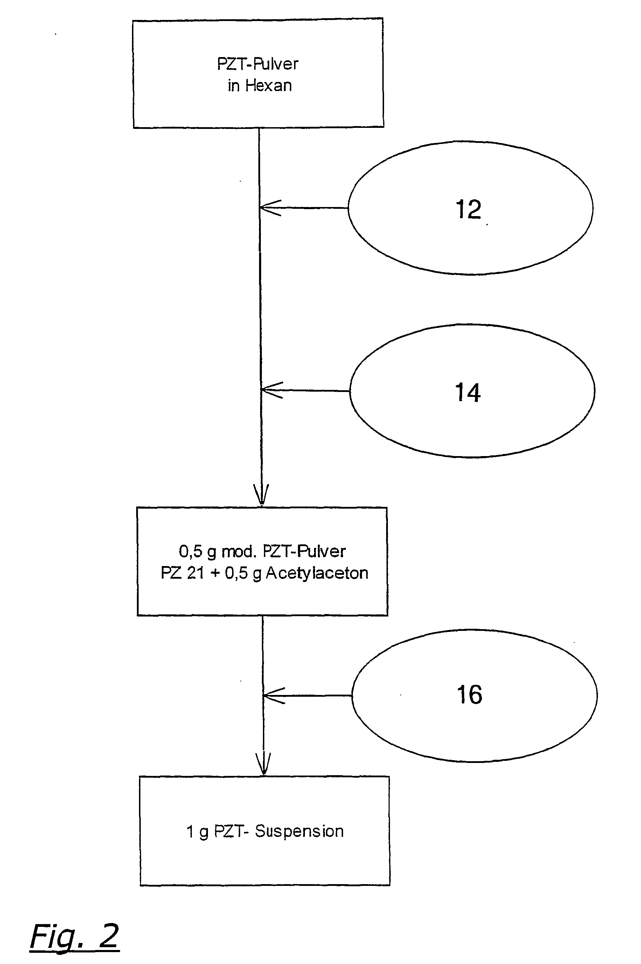

Vorzugsweise an die kurzzeitige (im Bereich von weniger als einer bis zu mehreren Minuten andauernde) Trocknung (14 in Fig. 2) abschließend eine Wärmebehandlung des mit der Schicht versehenen Substrats bei Temperaturen deutlich unter 100°C (bevorzugt unter 80°C) für mehrere Stunden im Trockenschrank durchgeführt, um durch Polymerisationsvorgänge im Matrixpolymer bessere mechanische Eigenschaften, insbesondere bessere Haltbarkeit, zu erzielen.

Im Folgenden werden die einzelnen Schritte am konkreten Beispiel von käuflichem PZT-Pulver und PMMA-Kunststoffpulver präzisiert. Die Übertragung des Verfahrens auf andere Substanzen ist für den Fachmann dann ersichtlich.

Das Hydrophobieren des Keramikpulvers sorgt für optimales Dispergieren in organischen Lösungsmitteln. Das Mahlen des Pulvers für typischweise 24 Stunden (12 in Fig. 2) führt auf Korngrößen deutlich unter 1 Mikrometer, vorzugsweise 100-200 Nanometer.

Das handelsübliche PZT-Pulver PZ 21 wird vorerst bei 800 °C wärmebehandelt, um eine vollständige Überführung der Keramikteilchen in die gewünschte Perowskitphase zu erzielen, und anschließend mit Ölsäure bei Raumtemperatur hydrophobiert.

Hierfür werden bezogen auf die Pulvermenge 10 % Ölsäure mit Oktan und dem Pulver gemischt und für 5 Stunden unter Rückfluss gekocht. Das hydrophobierte Pulver wird mit einer Zentrifuge vom Lösungsmittel abgetrennt, danach in Oktan zweimal gereinigt und im Trockenschrank bei 120 °C getrocknet. Dieses Pulver wird dann mehrere Stunden in Hexan in der Planetenkugelmühle nass gemahlen und wiederum getrocknet.

Die Herstellung von Polymerlösung und Keramikpulver-Suspension erfolgt bevorzugt im Lösungsmittel des Polymers. Alternativ kann das Keramikpulver auch in anderen organischen Lösungsmitteln suspendiert werden, sofern diese mit dem Lösungsmittel des Polymers kompatibel sind, d.h. es darf beim Vermengen von Keramiksuspension und Polymerlösung nicht zu Ausfällungen kommen.

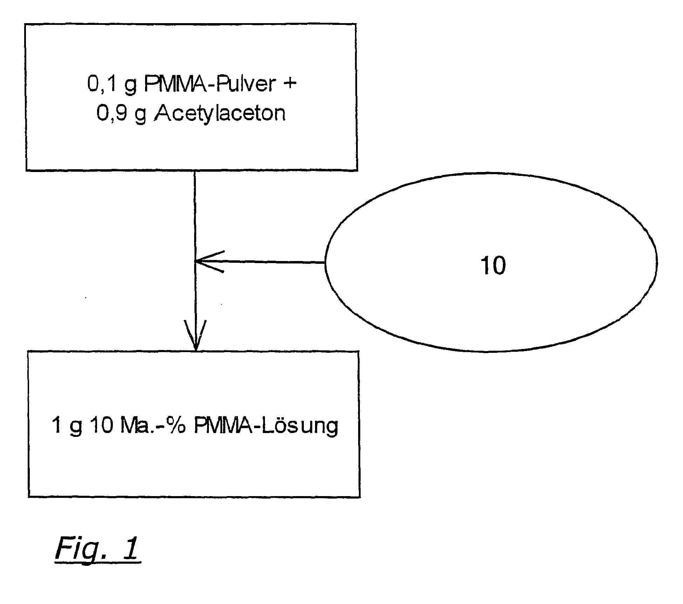

Für die PMMA-Lösung wird das Kunststoffpulver in Acetylaceton gelöst. Es wird eine 10 massenprozentige (Ma.-%ige) Lösung hergestellt. Bei 60°C löst sich das PMMA-Pulver innerhalb von 5 Minuten (10 in Fig. 1). Das Keramikpulver wird ebenfalls in Acetylaceton dispergiert, wobei hier vorzugsweise 50 Ma.-%ige Suspensionen erzeugt werden. Das PZT-Pulver wird dazu eingewogen, mit dem Lösungsmittel versetzt und mittels Ultraschall (3 mal 15 min) dispergiert (16 in Fig. 2).

Durch Mischen der beiden Stammlösungen in unterschiedlichen Verhältnissen können nun die Kompositschlicker mit verschiedenen Feststoffgehalten hergestellt werden. Wie sich zeigt, ist ein Mischungsverhältnis Keramik-Suspension / Polymerlösung zwischen 1:1 und 3:2 besonders vorteilhaft für die piezoelektrischen Eigenschaften der erzeugten Schicht. Dies entspricht einem mehr als 80 Ma.-%igen PZT-Feststoffgehalt in der getrockneten Schicht.

Der Kompositschlicker kann auf praktisch beliebige Substrate aufgebracht werden, wobei sich grundsätzlich alle in Sol-Gel-Verfahren üblichen Beschichtungsmethoden eignen. Für die dargestellten Beispiele werden vorgereinigte Silizium HD Wafer als Substrate gewählt. Bevorzugte Substrate sind jedoch MEMS-Wafer, Metallmembranen und weitere funktionale Substrate. Die Schichten werden mittels eines Spincoaters bei zunächst 800 Umdrehungen pro Minute (U/min) für 6 Sekunden und danach 1500 U/min für weitere 20 Sekunden aufgeschleudert. Nach dem Beschichten werden die Kompositschichten auf der Heizplatte für 1 Minute bei 100°C -110°C getrocknet.

Die Schichtherstellung ist hiermit bereits abgeschlossen. Besonders bevorzugt erfolgt jedoch noch eine weitere Wärmebehandlung der Schichten für 24 Stunden bei 80 °C im Trockenschrank. Der Sinn dieser Maßnahme ist das Bewirken zusätzlicher Polymerisationsprozesse in der Polymermatrix, die die Haltbarkeit der Schicht steigert. Vor allem für piezoelektrische Anwendungen des so beschichteten Substrats ist diese Nachbehandlung sehr ratsam.

Um die piezoelektrischen Eigenschaften der Kompositschichten zu bewerten, ist eine Polung der Schichten erforderlich. In hier gezeigten Beispielen werden verschiedene Proben (mit unterschiedlichem Feststoffgehalt) in einer Korona-Polungsanlage bei 15 kV und 80°C für ca. 30 Minuten gepolt. Das Feld bleibt auch beim Abkühlen für weitere 30 Minuten angelegt.

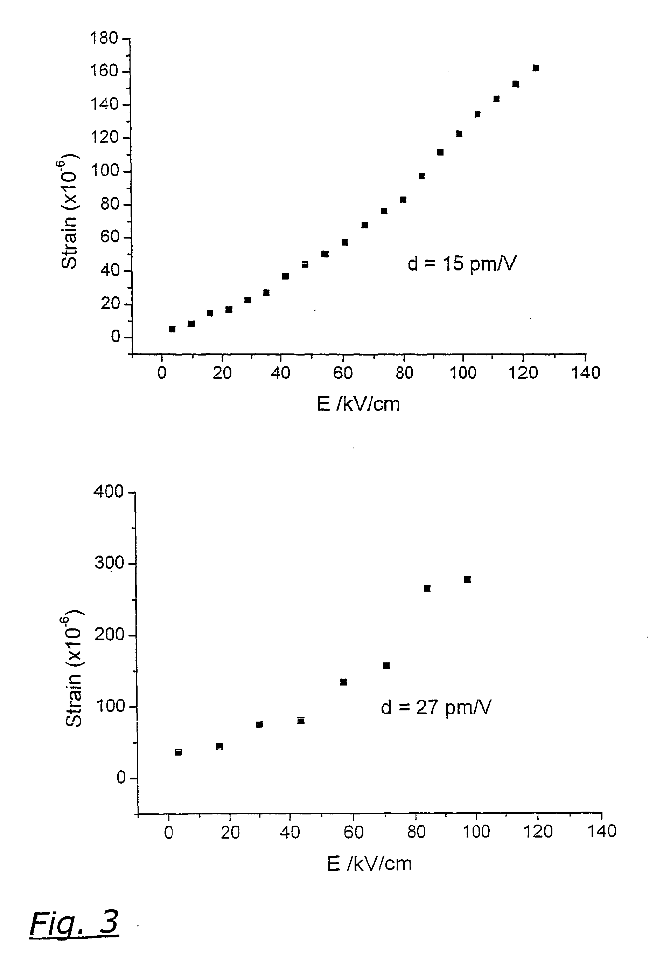

Fig. 3 zeigt die Ergebnisse der Dehnung (als Strain auf der y-Achse) in Dickenrichtung in Abhängigkeit von der angelegten Feldstärke für PMMA-PZT-Komposite mit 76,9 Ma.%igem (oberes Diagramm) und 88,2 Ma.-%igem Feststoffgehalt PZT (unteres Diagramm). Die ermittelten piezoelektrischen Koeffizienten von d(76,9) = 15 pm/V und d(88,2) = 27 pm/V verdeutlichen, dass die Wahl eines PZT-Feststoffgehalts oberhalb von 80 Ma.-% zu bevorzugen ist.

Zum Vergleich: die US 5,254,296 gibt d=30-35 pm/V als Maximalwerte für gestreckte und gepolte PVDF-Filme an, die mit den Maßnahmen der dort beschriebenen Erfindung auf bis zu 60 pm/V gesteigert werden können. Ungepolte PVDF-Filme liegen indes bei etwa d=14 pm/V. Derselben Quelle entnimmt man pyroelektrische Koeffizienten für gepolte und gestreckte PVDF-Filme um p=35 µC/m² K, die sich auf etwa p=60 µC/m²K mit den dort vorgeschlagenen Methoden steigern lassen.

Ein PVDF-PZT-Komposit ist nach dem hier beschriebenen Verfahren herstellbar, das nach Polung einen pyroelektrischen Koeffizienten von 67 µC/m²K aufweist. Die höchste Prozesstemperatur des Verfahrens bleibt auch hier im Bereich um 100°C.

## Patentansprüche

1. Verfahren zur Herstellung einer piezo- oder pyroelektrischen Dünnschicht auf einem Substrat, **gekennzeichnet durch** die Schritte :
a) Erzeugen einer Polymerlösung **durch** Lösen eines Polymers in einem organischen Lösungsmittel,
b) Erzeugen einer Keramikpulversuspension **durch** Suspendieren eines hydrophobierten, piezo- oder pyroelektrischen Keramikpulvers mit Korngrößen kleiner als 1 Mikrometer in einem mit dem Lösungsmittel des Polymers kompatiblen organischen Lösungsmittel,
c) Vermischen von Keramikpulver-Suspension und Polymerlösung zu einem Kompositschlicker,
d) Aufbringen dieses Kompositschlickers auf das Substrat unter Erzeugung einer Kompositschicht,
e) Trocknen der aufgebrachten Schicht bei Temperaturen um 100°C.

2. Verfahren nach Anspruch 1, **dadurch gekennzeichnet, dass** eine weitere Wärmebehandlung des beschichteten Substrats für mehrere Stunden bei Temperaturen unter 100°C erfolgt.

3. Verfahren nach einem der vorangehenden Ansprüche, **dadurch gekennzeichnet, dass** Polymerlösung und Keramikpulversuspension in einem Verhältnis gemischt werden, das in der fertigen Schicht einen Feststoffgehalt von wenigstens 80 Massenprozent Keramik erzeugt.

4. Verfahren nach einem der vorangehenden Ansprüche, **dadurch gekennzeichnet, dass** das Keramikpulver im Lösungsmittel des Polymers suspendiert wird.

5. Verfahren nach einem der vorangehenden Ansprüche, **dadurch gekennzeichnet, dass** der Kompositschlicker durch Aufschleudern auf das Substrat gebracht wird.

6. Verfahren nach einem der vorangehenden Ansprüche, **dadurch gekennzeichnet, dass** das Substrat ein siliziumbasiertes mikromechanisches System (MEMS) ist.

7. Verfahren nach einem der vorangehenden Ansprüche, **dadurch gekennzeichnet, dass** das Keramikpulver Bleizirkonattitanat (PZT) ist.

8. Verfahren nach einem der vorangehenden Ansprüche, **dadurch gekennzeichnet, dass** das Polymer Polymethylmethacrylat (PMMA) ist.

9. Verfahren nach einem der Ansprüche 1 bis 7, **dadurch gekennzeichnet, dass** das Polymer ein piezoelektrisches Polymer, insbesondere PVDF, ist.

10. Verfahren nach Anspruch 2 oder einem der davon abhängigen Ansprüche, **dadurch gekennzeichnet, dass** die fertige Schicht anschließend einer Koronapolung bei mehr als 10 kV und Temperaturen im Bereich der Wärmebehandlung unterzogen wird.

## Claims

1. Process for producing a piezoelectric or pyroelectric thin layer on a substrate, **characterized by** the steps of:
a) obtaining a polymer solution by dissolving a polymer in an organic solvent,
b) obtaining a ceramic powder suspension by suspending a hydrophobized piezoelectric or pyroelectric ceramic powder with particle sizes less than 1 micrometre in an organic solvent compatible with the solvent of the polymer,
c) mixing the ceramic powder suspension and polymer solution to give a composite slip,
d) applying this composite slip to the substrate to obtain a composite layer,
e) drying the layer applied at temperatures around 100°C.

2. Process according to Claim 1, **characterized in that** a further heat treatment of the coated substrate is effected at temperatures below 100°C for several hours.

3. Process according to either of the preceding claims, **characterized in that** the polymer solution and ceramic powder suspension are mixed in such a ratio as to obtain a solids content of at least 80% by mass in the finished layer.

4. Process according to any of the preceding claims, **characterized in that** the ceramic powder is suspended in the solvent of the polymer.

5. Process according to any of the preceding claims, **characterized in that** the composite slip is applied to the substrate by spin-coating.

6. Process according to any of the preceding claims, **characterized in that** the substrate is a silicon-based micromechanical system (MEMS).

7. Process according to any of the preceding claims, **characterized in that** the ceramic powder is lead zirconate titanate (PZT).

8. Process according to any of the preceding claims, **characterized in that** the polymer is polymethyl methacrylate (PMMA).

9. Process according to any of Claims 1 to 7, **characterized in that** the polymer is a piezoelectric polymer, especially PVDF.

10. Process according to Claim 2 or any of the claims dependent thereon, **characterized in that** the finished layer is subsequently subjected to corona poling at more than 10 kV and temperatures within the range of the thermal treatment.

## Revendications

1. Procédé de réalisation d'une mince couche piézoélectrique ou pyroélectrique sur un substrat, **caractérisé par** les étapes qui consistent à :
a) former une solution de polymère en dissolvant un polymère dans un solvant organique,
b) former une suspension de poudre de céramique en mettant en suspension une poudre de céramique piézoélectrique ou pyroélectrique rendue hydrophobe et dont les grains ont une taille inférieure à 1 micromètre dans un solvant organique compatible avec le solvant du polymère,
c) mélanger la suspension de poudre de céramique et la solution de polymère pour former une barbotine composite,
d) appliquer cette barbotine composite sur le substrat pour former une couche de composite et
e) sécher à une température d'environ 100°C la couche appliquée.

2. Procédé selon la revendication 1, **caractérisé en ce qu'**un autre traitement thermique du substrat revêtu s'effectue pendant plusieurs heures à une température inférieure à 100°C.

3. Procédé selon l'une des revendications précédentes, **caractérisé en ce que** la solution de polymère et la suspension de poudre de céramique sont mélangées dans un rapport tel que l'on obtient dans la couche terminée une teneur en solides de 80 pourcent en masse de céramique.

4. Procédé selon l'une des revendications précédentes, **caractérisé en ce que** la poudre de céramique est mise en suspension dans le solvant du polymère.

5. Procédé selon l'une des revendications précédentes, **caractérisé en ce que** la barbotine composite est appliquée sur le substrat par centrifugation.

6. Procédé selon l'une des revendications précédentes, **caractérisé en ce que** le substrat est un système micromécanique à base de silicium (MEMS).

7. Procédé selon l'une des revendications précédentes, **caractérisé en ce que** la poudre de céramique est du zirconate-titanate de plomb (PZT).

8. Procédé selon l'une des revendications précédentes, **caractérisé en ce que** le polymère est le poly(méthacrylate de méthyle) (PMMA).

9. Procédé selon l'une des revendications 1 à 7, **caractérisé en ce que** le polymère est un polymère piézoélectrique et en particulier le PVDF.

10. Procédé selon la revendication 2 ou l'une des revendications qui en dépendent, **caractérisé en ce que** la couche terminée subit ensuite une polarisation par effet corona à plus de 10 kV et à une température comprise dans la plage de celles du traitement thermique.
